# EUROPÄISCHE PATENTSCHRIFT

(11) **EP 0 631 306 B1**
(45) Veröffentlichungstag und Bekanntmachung des Hinweises auf die Patenterteilung: **26.04.2000**
(21) Anmeldenummer: 94108804.9
(22) Anmeldetag: 08.06.1994
(51) Int. Cl.: H01L 21/76, H01L 21/225

(54) **Verfahren zur Herstellung von einem Isolationsgraben in einem Substrat für Smart-Power-Technologien**
Process for manufacturing an isolation region in a substrate for smart-power-technology
Procédé de fabrication d'une région d'isolation dans un substrat pour la technologie de puissance intélligente

(30) Priorität: 23.06.1993 DE 4320885
(43) Veröffentlichungstag der Anmeldung: 28.12.1994
(73) Patentinhaber: SIEMENS AKTIENGESELLSCHAFT, 80333 München (DE)
(72) Erfinder: Schwalke, Udo, Dr., D-84431 Heldenstein (DE)

(56) Entgegenhaltungen:
- EP-A- 0 265 958
- EP-A- 0 295 786
- EP-A- 0 296 754
- EP-A- 0 515 809
- WO-A-85/04760
- WO-A-86/04454
- US-A- 4 666 556
- EXTENDED ABSTRACTS OF THE 20TH (1988 INTERNATIONAL ) CONFERENCE ON SOLID STATE DEVICES ANS MATERIALS TOKYO 1988, 1988, TOKYO Seiten 33 - 36 A. NAKAGAWA ET AL. '500 V LATERAL DOUBLE GATE BIPOLAR-MODE MOSFET(DGIGBT) DIELECTRICALLY ISOLATED BY SILICON WAFER DIRECT-BONDING (DISDB)'
- IBM TECHNICAL DISCLOSURE BULLETIN., Bd.27, Nr.10A, März 1985, NEW YORK US Seiten 5501 - 5504 'SIDEWALL CHANNEL-STOP DOPING FOR DEEP-TRENCH ISOLATION OF FET DEVICES'
- JOURNAL OF THE ELECTROCHEMICAL SOCIETY, Bd.139, Nr.6, Juni 1992, MANCHESTER, NEW HAMPSHIRE US Seiten 1690 - 1692 K. FUJINO ET AL. 'SURFACE MODIFICATION OF BASE MATERIALS FOR TEOS/O3 ATMOSPHERIC PRESSURE CHEMICAL VAPOR DEPOSITION.'

## Beschreibung

In der Smart-Power-Technologie werden komplexe Bauelemente mit Hochspannungs-Leistungsbauelementen monolithisch in einem Substrat integriert. Da die Logikbauelemente mit Spannungspegeln um 5 Volt betrieben werden, bei den Hochspannungs-Leistungsbauelementen jedoch Spannungen bis zu 500 Volt auftreten, ist eine elektrische Trennung der Hochspannungsbauelemente von den Logikbauelementen erforderlich.

Es ist bekannt (siehe zum Beispiel Yu Ohata et al, IEEE 1987 CICC, S. 443 - 446 und A. Nakagawa et al. ISPS 1990, S. 97 - 101), die Hoch- und Niederspannungsbauelemente durch dielektrische Isolation elektrisch vollständig gegeneinander zu isolieren. Dazu werden die Bauelemente in einem SOI-Substrat realisiert. Ein SOI-Substrat umfaßt auf einer einkristallinen Siliziumscheibe eine isolierende Schicht aus SiO₂ und auf der isolierenden Schicht eine einkristalline Siliziumschicht, die die Oberfläche des SOI-Substrats umfaßt. Die isolierende Schicht des SOI-Substrats stellt die vertikale Isolation sicher, während die laterale Isolation der Bauelemente durch mit isolierendem Material gefüllte Gräben realisiert wird. Für viele Anwendungen wird das Spannungsverhalten der Bauelemente dadurch verbessert, daß vor dem Auffüllen der Gräben mit Oxid die Seitenwände der Gräben über die gesamte Tiefe bis zur isolierenden Schicht des SOI-Materials n⁺- oder p⁺-dotiert werden (siehe N. Yasuhara et al, IEDM 1991, S. 141 - 144).

Zur Herstellung der lateralen Isolierung ist es bekannt, nach der Ätzung des Grabens zunächst die Dotierung der Seitenwände durchzuführen. Diese Dotierung erfolgt zum Beispiel durch Ausdiffusion aus dotierten Gläsern wie BSG oder PSG (siehe zum Beispiel EP-441482-A), durch Belegung aus der Gasphase (siehe zum Beispiel EP-430168-A) oder durch Ionenimplantation. Da in Smart-Power-Technologien Grabentiefen um 20 µm mit Aspektverhältnissen (das ist der Quotient Grabentiefe zu Grabenbreite) von 5 bis 10 auftreten, ist es problematisch, durch Ionenimplantation bei der Dotierung der Seitenwände ein Diffusionsgebiet mit einer gleichförmigen, vorgebbaren Ausdehnung herzustellen. Bei der Dotierung durch Ausdiffusion aus Gläsern oder Belegung aus der Gasphase muß nach der Bildung des Diffusionsgebietes die Schicht aus dotiertem Glas oder die Belegungsschicht wieder entfernt werden, um eine unkontrollierte Ausdiffusion aus diesen Schichten oder eine Kontamination des Equipments im weiteren Prozeßablauf zu vermeiden. Die als Dotierquellen dienenden Schichten müssen daher restefrei entfernt werden. Es besteht dabei die Gefahr, daß die isolierende Schicht des SOI-Substrats dabei angegriffen wird, da am Boden des Grabens kein Ätzstop vorhanden ist.

Das Auffüllen des Grabens erfolgt anschließend. Da der Graben ein hohes Aspektverhältnis aufweist, kann er nicht ohne weiteres lunkerfrei gefüllt werden. SiO₂-Schichten, die in CVD-Verfahren unter Atmosphärendruck (APCVD) abgeschieden werden, können dieses Erfordernis wegen der unzureichenden Konformität der Schicht nicht erfüllen. Wird die SiO₂-Schicht in einem CVD-Verfahren bei niedrigem Druck (LPCVD) abgeschieden, so verbessert zwar ihre Konformität, die Abscheideraten sind jedoch zu gering, um eine Auffüllung des Grabens in für die Fertigung akzeptabler Zeit zu erreichen.

Aus A. Nakagawa et al. ISPS 1990, S. 97 - 101 ist bekannt, das Problem der CVD-Abscheidung dadurch zu umgehen, daß der Graben thermisch aufoxidiert wird. Dabei verbleibt ein Zwischenraum, der mit Polysilizium aufgefüllt wird. Das Polysilizium wird rückgeätzt und anschließend aufoxidiert.

Eine andere Möglichkeit, die Probleme der CVD-Abscheidung zu umgehen, ist aus EP-444836-A bekannt. Dabei wird der Graben zunächst mit einer dünnen isolierenden Schicht aus SiO₂und Si₃N₄ ausgekleidet. Nachfolgend wird Polysilizium abgeschieden, rückgeätzt und aufoxidiert.

Ferner ist aus EP 0 296 754 A2 bekannt, zur Vermeidung von Spannungen beim Auffüllen von Gräben in SOI-Substraten zunächst durch thermische Oxidation an der Oberfläche der Siliziumschicht des SOI-Substrats eine dünne Oxidschicht zu bilden. Anschließend wird eine Schicht aus Polysilizium abgeschieden und oxidiert.

Aus WO-A-8504760 ist bekannt, zur Erzeugung von dotierten Gebieten in Seitenwänden von Gräben in Siliziumsubstraten eine Polysiliziumschicht abzuscheiden. Im oberen Bereich des Grabens und am Boden des Grabens wird die Polysiliziumschicht anschließend durch Implantation dotiert. Es wird ein Temperschritt durchgeführt, bei dem die Dotierstoffe innerhalb der Polysiliziumschicht diffundieren und sich gleichmäßig verteilen. Schließlich wird ein weiterer Temperschritt durchgeführt, bei dem die Polysiliziumschicht oxidiert wird.

Aus EP 0 295 786 A2 ist ein Verfahren zur Herstellung eines SOI-Substrats bekannt, bei dem eine durchgehende Siliziumschicht durch laterales epitaktisches Überwachsen gebildet wird.

Aus US-PS 4 666 556 ist bekannt, zur Erzeugung einer ätzresistenten Siliziumdioxidschicht auf der Oberfläche eines Grabens, der in einem Siliziumsubstrat gebildet ist, eine konforme Schicht aus Polysilizium abzuscheiden und diese durch thermische Oxidation in Siliziumdioxid zu verwandeln.

Aus WO-A-8604454 ist bekannt, zur Erzeugung von bordotierten Gebieten in Seitenwänden von Gräben in Siliziumsubstraten eine SiO₂-Schicht zu erzeugen und darauf eine Polysiliziumschicht abzuscheiden. Die Polysiliziumschicht wird dotiert. In einem Temperschritt in Wasserdampfatmosphäre wird Bor durch die SiO₂-Schicht in das Siliziumsubstrat eindiffundiert. Durch einen zusätzlichen Temperschritt in Inertgasatmosphäre kann das Bor weiter in das Siliziumsubstrat eindiffundiert werden, ohne daß aus der Polysiliziumschicht weiteres Bor durch die SiO₂-Schicht diffundiert.

Aus Journal of the Electrochemical Scoiety, Bd. 139, Nr. 6, Juni 1992, Seiten 1690 bis 1692, ist ein Verfahren zur Abscheidung von SiO₂ unter Verwendung von TEOS und O₃ in einem CVD-Verfahren bekannt.

Der Erfindung liegt das Problem zugrunde, ein Verfahren zur Herstellung von einem Isolationsgraben in einem SOI-Substrat, in dem Logikbauelemente und Hochspannungs-Leistungsbauelemente integriert sind, anzugeben, mit dem in den Seitenwänden des Grabens Diffusionsgebiete definierter Ausdehnung herstellbar sind, bei dem ein Durchätzen der isolierenden Schicht des SOI-Substrats vermieden wird und mit dem der Graben lunkerfrei aufgefüllt werden kann.

Dieses Problem wird erfindungsgemäß gelöst durch ein Verfahren im Anspruch 1. In dem erfindungsgemäßen Verfahren wird die dotierte Siliziumstruktur sowohl als Diffusionsquelle zur Herstellung von dem Graben benachbarten Diffusionsgebiet als auch zur Auffüllung des Grabens durch Aufoxidation der dotierten Siliziumstruktur verwendet. Da die Diffusionsquelle, nach Oxidation zu SiO₂, als Grabenfüllung verwendet wird, entfällt das Entfernen der Diffusionsquelle und die damit verbundene Gefahr des Freiätzens der isolierenden Schicht.

Die Ausdiffusion aus der dotierten Siliziumstruktur und die Aufoxidation der dotierten Siliziumstruktur erfolgt in einem gemeinsamen Schritt. Es ist vorteilhaft, die Ausdiffusion aus der dotierten Siliziumstruktur in oxidierender Atmosphäre durchzuführen, da es dann gleichzeitig mit der Ausdiffusion zur Aufoxidation der dotierten Siliziumstruktur kommt und ein Prozeßschritt eingespart werden kann.

Es liegt im Rahmen der Erfindung, zur Bildung der dotierten Siliziumstruktur, eine dotierte Siliziumschicht mit im wesentlichen konformer Kantenbedeckung abzuscheiden. Die dotierte Siliziumstruktur wird dann durch Strukturierung der dotierten Siliziumschicht erzeugt.

Die dotierte Siliziumschicht im Graben wird in situ dotiert abgeschieden. Dadurch wird eine gleichmäßige Verteilung des Dotierstoffs in der dotierten Siliziumschicht sichergestellt. Ferner wird der Prozeß durch die in situ dotierte Abscheidung der Schicht vereinfacht.

Die dotierte Siliziumschicht wird als amorphe Schicht abgeschieden, da amorphes Silizium eine bessere Homogenität als polykristallines Silizium zeigt.

Vorzugsweise wird zur Ätzung des Grabens eine Grabenmaske verwendet, die mindestens an ihrer Oberfläche SiO₂ umfaßt. Die Ätzung des Grabens erfolgt dann selektiv zu SiO₂. Die isolierende Schicht des SOI-Substrats stellt dann einen Ätzstop dar, da diese ebenfalls aus SiO₂ besteht.

Die dotierte Siliziumschicht wird vor der Ausdiffusion anisotrop selektiv zu SiO₂ rückgeätzt, so daß waagerechte Oberflächen der Grabenmaske und der isolierenden Schicht des SOI-Substrats freigelegt werden. An senkrechten Flanken der monokristallinen Siliziumschicht und der Grabenmaske verbleiben selbstjustierte dotierte Siliziumspacer, die die dotierte Siliziumstruktur bilden. Durch Ausdiffusion aus den Siliziumspacern werden die Diffusionsgebiete hergestellt. Da die Anteile der dotierten Siliziumschicht auf waagerechten Oberflächen des Substrats entfernt sind, wird so auf einfache Weise eine planare Struktur erzeugt.

Zum vollständigen Auffüllen des Grabens liegt es im Rahmen der Erfindung, schließlich eine weitere Siliziumschicht abzuscheiden, die den Freiraum innerhalb der Isolationsstruktur im Graben auffüllt und an deren Oberfläche durch Aufoxidieren selbstjustiert eine SiO₂-Abdeckung gebildet wird.

Gemäß einer anderen Ausführungsform wird der Freiraum innerhalb der Isolationsstruktur im Graben durch Abscheidung von SiO₂ in einem O₃-TEOS-CVD-Verfahren, wie es aus S. Fischer et al, ECS, Ext. Abstr., Vol. 92-2 (1992), S. 381 bekannt ist, aufgefüllt.

Weitere Ausgestaltungen der Erfindung gehen aus den übrigen Ansprüchen hervor.

Im folgenden wird die Erfindung anhand der Figuren und eines Ausführungsbeispiels näher erläutert.
- Figur 1: zeigt ein SOI-Substrat mit einer Grabenmaske.
- Figur 2: zeigt das SOI-Substrat nach der Grabenätzung.
- Figur 3: zeigt das SOI-Substrat nach der Abscheidung der dotierten Siliziumschicht.
- Figur 4: zeigt das SOI-Substrat nach Rückätzen der dotierten Siliziumschicht.
- Figur 5: zeigt das SOI-Substrat nach Ausdiffusion aus und Aufoxidation der dotierten Siliziumschicht.
- Figur 6: zeigt das SOI-Substrat nach Auffüllen des verbleibenden Freiraums im Graben mit einer weiteren Siliziumschicht.
- Figur 7: zeigt das SOI-Substrat nach Rückätzen der weiteren Siliziumschicht.
- Figur 8: zeigt das SOI-Substrat nach Entfernen der oberen Schicht der Grabenmaske.
- Figur 9: zeigt das SOI-Substrat nach Bildung einer SiO₂-Abdeckung im oberen Bereich des Grabens.
- Figur 10 und Figur 11: zeigen durch Simulationsrechnungen bestimmte Dotierstoffverteilungen vor und nach der Ausdiffusion und Aufoxidation der dotierten Siliziumschicht.

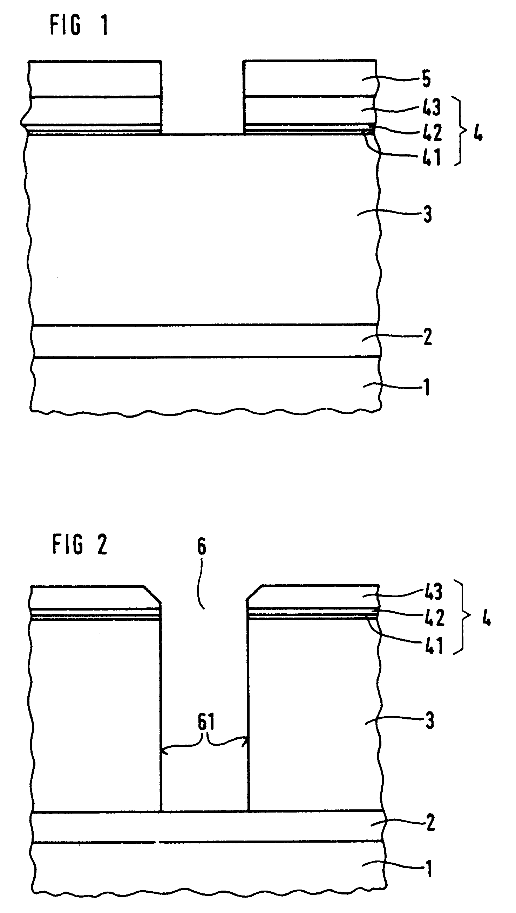

Ein SOI-Substrat umfaßt eine monokristalline Siliziumscheibe 1, die zum Beispiel p⁺-dotiert ist, eine darauf angeordnete isolierende Schicht 2 aus SiO₂ und eine darauf angeordnete monokristalline Siliziumschicht 3 (siehe Figur 1). Das SOI-Substrat ist vorzugsweise nach dem direct wafer bonding (DWB) oder silicon direct bonding (SDB)-Verfahren, das zum Beispiel aus Yu Ohata et al, IEEE 1987, S. 443- 446, bekannt ist, hergestellt. Die Dicke der isolierenden Schicht 2 beträgt zum Beispiel 2 µm Die Dicke der monokristallinen Siliziumschicht 3 beträgt zum Beispiel 20 µm. Die monokristalline Siliziumschicht 3 ist zum Beispiel schwach n-dotiert. Die Dotierstoffkonzentration in der monokristallinen Siliziumschicht 3 beträgt zum Beispiel 10¹⁴ Phosphoratome/cm³. In der monokristallinen Siliziumschicht 3 werden später die Bauelemente hergestellt.

Auf die Oberfläche der monokristallinen Siliziumschicht 3 wird eine Grabenmaske 4 aufgebracht. Die Grabenmaske 4 umfaßt eine untere Schicht 41, eine mittlere Schicht 42 und eine obere Schicht 43. Die untere Schicht 41 wird zum Beispiel durch thermische Oxidation in einer Dicke von 50 nm hergestellt. Die mittlere Schicht 42 wird zum Beispiel durch CVD-Abscheidung von Si₃N₄ in einer Dicke von 150 nm hergestellt. Die obere Schicht 43 wird zum Beispiel durch CVD-Abscheidung von SiO₂ in einer Dicke von 1600 nm hergestellt. Zur Strukturierung der Grabenmaske 4 wird auf diese Schichtenfolge eine Lackmaske 5 aufgebracht. Die Grabenmaske 4 wird mit Hilfe der Lackmaske 5 in einem CHF₃/O₂-Trockenätzprozeß strukturiert. Die Grabenmaske muß zum Ätzen eines tiefen Grabens geeignet sein.

Nach Entfernen der Lackmaske 5 durch Lackstrippen wird mit Hilfe der Grabenmaske 4 ein Graben 6 in die monokristalline Siliziumschicht 3 geätzt (siehe Figur 2). Die Ätzung erfolgt zum Beispiel anisotrop in einem Trockenätzprozeß mit einer Cl₂/O₂-Chemie. Die Ätzung erfolgt selektiv zu SiO₂. Daher stopt die Ätzung sobald die Oberfläche der isolierenden Schicht 2 freigelegt ist.

Zur Bildung von sauberen Seitenwänden 61 des Grabens 6 werden an den Seitenwänden befindliche Ätzprodukte in einem HF-Dip entfernt.

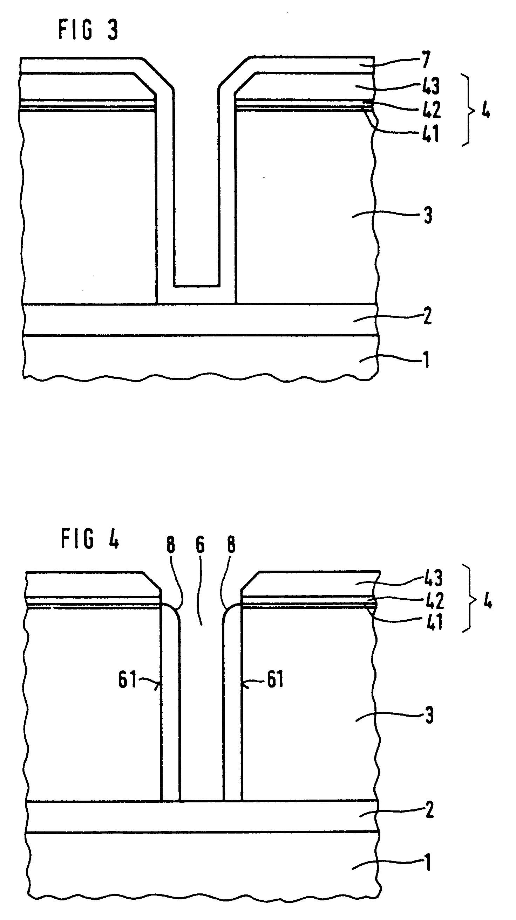

Auf die Oberfläche der Grabenmaske 4, die Seitenwände 61 des Grabens und die freiliegende Oberfläche der isolierenden Schicht 2 wird eine dotierte Siliziumschicht 7 abgeschieden (siehe Figur 3). Die dotierte Siliziumschicht 7 wird in situ dotiert. Die dotierte Siliziumschicht 7 besteht aus amorphem Silizium und weist eine Dotierstoffkonzentration von zum Beispiel 4 . 10²⁰ cm⁻³ Bor auf. Die dotierte Siliziumschicht 7 wird bei 400 bis 550°C abgeschieden. Dabei wird der Dotierstoff im amorphen Silizium eingebettet, er wird jedoch noch nicht aktiviert. Die dotierte Siliziumschicht 7 wird mit im wesentlichen konformer Kantenbedeckung abgeschieden. Das heißt, daß die Schichtdicke der dotierten Siliziumschicht 7 an waagerechten und an senkrechten Unterlagen im wesentlichen gleich ist. Die Dicke der dotierten Siliziumschicht 7 wird auf die Weite und die Geometrie des Grabens 6 abgestimmt. Bei einer Weite des Grabens 6 von zum Beispiel 2 µm wird die dotierte Siliziumschicht 7 zum Beispiel in einer Dicke von 400 nm abgeschieden.

In einem anisotropen Trockenätzprozeß zum Beispiel in einem HBr/Cl₂-Plasma wird die dotierte Siliziumschicht 7 geätzt, bis waagerechte Oberflächen der Grabenmaske 4 und der isolierenden Schicht 2 freigelegt sind (siehe Figur 4). Dabei entstehen an den Seitenwänden 61 des Grabens 6 Spacer 8 aus dotiertem Silizium.

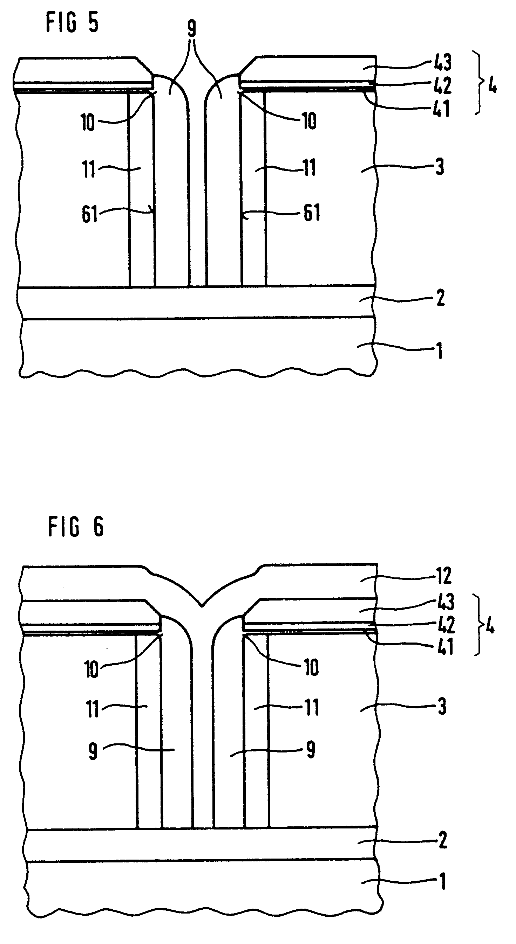

Durch eine Temperaturbehandlung bei 1000°C in feuchter Atmosphäre diffundiert Dotierstoff aus den Spacern 8 in die monokristalline Siliziumschicht 3 und bildet dort, dem Graben 6 benachbart, Diffusionsgebiete 11 (siehe Figur 5). Gleichzeitig rekristallisiert das amorphe Silizium der Spacer 8 zum Teil. Dabei bildet sich eine Isolationsstruktur 9 sowie einen SiO₂-Vogelschnabel 10 an der oberen Kante der monokristallinen Siliziumschicht 3. Die Temperaturbehandlung wird mindestens solange fortgesetzt, bis die zur Isolation erforderliche Oxiddicke erreicht ist. Der SiO₂-Vogelschnabel 10 bildet sich durch Oxidation von Silizium der monokristallinen Siliziumschicht 3. Die Isolationsstruktur 9 bildet sich durch Oxidation von Silizium der Spacer 8. Die Dotierstoffkonzentration in dem Diffusionsgebiet 11 stellt sich je nach Dotierung der Spacer 8 ein.

Durch Abscheidung einer weiteren Siliziumschicht 12 wird noch verbliebener Freiraum im Graben 6 aufgefüllt (siehe Figur 6). Die weitere Siliziumschicht 12 besteht zum Beispiel aus amorphem Silizium (siehe Figur 6).

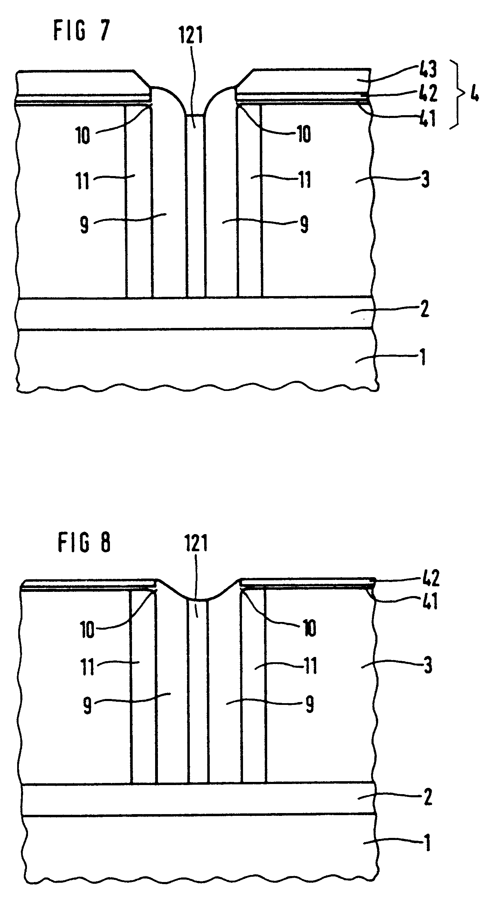

Durch Rückätzen, zum Beispiel durch Trockenätzen in einem HBr/Cl₂-Plasma, wird die Oberfläche der oberen Schicht 43 der Grabenmaske 4 freigelegt. In dem Freiraum des Grabens 6 verbliebenes amorphes Silizium der weiteren Siliziumschicht 12 bildet dabei eine Siliziumfüllung 121 (siehe Figur 7). Die Ätzung wird solange fortgesetzt, bis die Oberkante der Siliziumfüllung 121 unterhalb der unteren Schicht 41 aus thermischem SiO₂ der Grabenmaske 4 abschließt.

Anschließend wird die obere Schicht 43 der Grabenmaske 4 durch eine Ätzung mit zum Beispiel CHF₃/O₂ entfernt (siehe Figur 8). Die Ätzung erfolgt selektiv zu Si₃N₄, so daß sie auf der Oberfläche der mittleren Schicht 42 der Grabenmaske 4 stopt. Bei dieser Ätzung wird die Isolationsstruktur 9, die ebenfalls aus SiO₂ besteht, im oberen Bereich rückgeätzt, so daß die Isolationsstruktur 9 anschließend in der Höhe in etwa mit der mittleren Schicht 42 der Grabenmaske 4 abschließt.

In einem Temperaturschritt bei 1000°C in feuchter Atmosphäre wird die Oberfläche der Siliziumfüllung 121 aufoxidiert. Dabei entsteht ein Isolationsabschluß 13, der die Siliziumfüllung 121 vollständig abdeckt. Der Isolationsabschluß 13 entsteht ohne Verwendung einer Maskentechnik, das heißt selbstjustiert. Gleichzeitig mit der Bildung des Isolationsabschlusses 13 bildet sich der SiO₂-Vogelschnabel 10 an der oberen Kante der monokristallinen Siliziumschicht 13 weiter aus. Er trägt durch Kantenverrundung zur Erhöhung der Durchbruchsspannung bei.

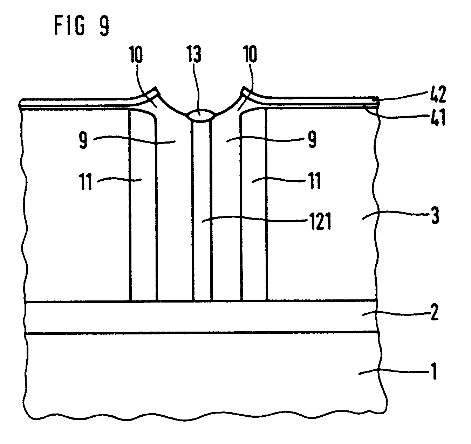

Der innerhalb der Isolationsstruktur 9 verbliebene Freiraum (siehe Figur 5) kann alternativ zu dem anhand von Figur 6 bis Figur 9 beschriebenen Verfahren durch konforme Abscheidung von SiO₂ zum Beispiel in einem O₃/TEOS-Verfahren aufgefüllt werden. Dazu wird ein CVD-Verfahren durchgeführt, in dem ein O₃ und Si(OC₂H₅)₄ enthaltendes Prozeßgas verwendet wird. Das CVD-Verfahren wird zum Beispiel bei einem Druck im Bereich von 50 - 600 Torr und einer Temperatur im Bereich von 200 - 600°C durchgeführt. Der Anteil O₃ im Prozeßgas beträgt 0,5 - 6 Gewichtsprozent. In diesem Verfahren wird der im Graben verbliebene Freiraum vollständig mit SiO₂ aufgefüllt.

Anschließend werden in der monokristallinen Siliziumschicht 3 die Logikbauelemente und die Hochspannungsbauelemente hergestellt.

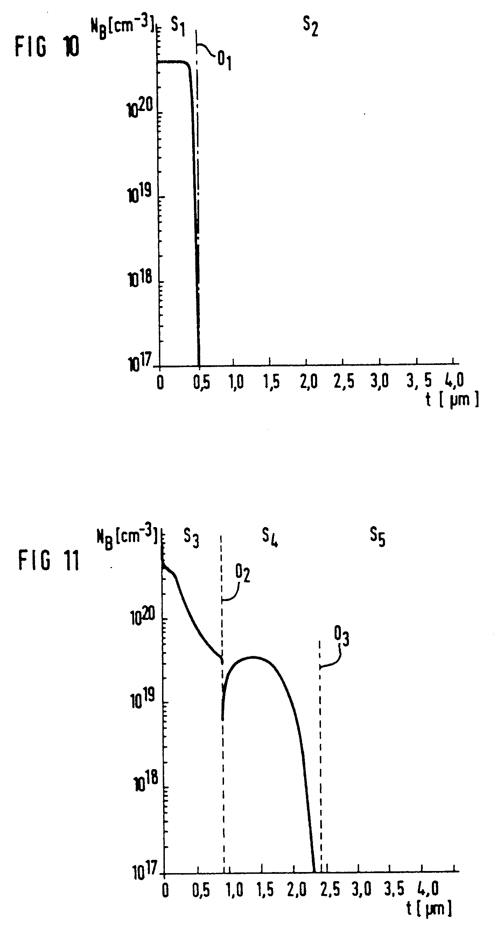

Figur 10 zeigt die Borverteilung einer auf einem Substrat angeordneten, bordotierten Siliziumschicht. Die gestrichelte Linie O₁ deutet die Oberfläche des Siliziumsubstrats an. Das Siliziumsubstrat ist mit 10¹⁵ Phosphoratomen pro cm³ dotiert. Die bordotierte Siliziumschicht weist eine Dicke von 500 nm auf und ist mit 4 x 10²⁰cm⁻³ Bor dotiert. In Figur 10 ist der der dotierten Siliziumschicht entsprechende Bereich mit S₁ und der dem Substrat entsprechende Bereich mit S₂ bezeichnet. Die Bordotierstoffkonzentration zeigt eine steile Abnahme im Bereich der Oberfläche O₁ des Substrats S₂.

Figur 11 zeigt die Borverteilung nach Ausdiffusion und Oxidation der dotierten Siliziumschicht in feuchter Atmosphäre bei 1000°C. Aus der dotierten Siliziumschicht wird durch Oxidation eine SiO₂-Schicht, der der mit S₃ bezeichnete Bereich in Figur 11 entspricht. Durch Ausdiffusion entsteht in der Oberfläche des Substrats ein p-dotiertes Diffusionsgebiet. Dem Diffusionsgebiet entspricht in Figur 11 der mit S₄ bezeichnete Bereich. In dem in Figur 11 mit S₅ bezeichneten Bereich herrscht die Ausgangsdotierung des Substrats vor. Die mit O₂ bezeichnete gestrichelte Linie in Figur 11 entspricht der Oberfläche des Substrats. Die mit O₃ bezeichnete gestrichelte Linie in Figur 11 entspricht der Begrenzung des Diffusionsgebietes. Figur 10 und Figur 11 sind das Ergebnis von Simulationsrechnungen, mit denen verifiziert wurde, daß bei 1000°C in feuchter Atmosphäre zugleich sowohl eine vollständige Oxidation einer amorphen Siliziumschicht als auch die Ausdiffusion und Bildung des Diffusionsgebietes möglich ist.

Da in dem erfindungsgemäßen Verfahren gleichzeitig eine Dotierung der Seitenwände des Grabens und ein Auffüllen des Grabens erfolgt, ergibt sich eine vereinfachte Prozeßführung.

Ein weiterer Vorteil des erfindungsgemäßen Verfahrens besteht darin, daß die Prozeßschritte zur Dotierung der Seitenwand des Grabens und zur Füllung des Grabens konventionelle Prozeßschritte aus der CMOS-Technologie sind. Da zur Herstellung der Logikbauelemente ohnehin derartige CMOS-Prozesse erforderlich sind, heißt das, daß nur mit CMOS-Prozessen verträgliche Schritte verwendet werden.

Durch den selbstjustierten Isolationsabschluß an der Oberfläche des Grabens bei gleichzeitiger Kantenverrundung und Ausbildung eines vergrößerten SiO₂-Vogelschnabels werden verbesserte elektrische Eigenschaften erzielt.

## Patentansprüche

1. Verfahren zur Herstellung eines Isolationsgrabens in einem SOI-Substrat, in dem Logikbauelemente und Hochspannungs-Leistungsbauelemente integriert sind,
- bei dem das SOI-Substrat eine monokristalline Siliziumscheibe (1), eine darauf angeordnete isolierende Schicht (2) aus SiO₂ und eine darauf angeordnete monokristalline Siliziumschicht (3) umfaßt,
- bei dem in die monokristalline Siliziumschicht (3) mit Hilfe einer Grabenmaske (4) ein Graben (6) geätzt wird, der bis auf die isolierende Schicht (2) reicht,
- bei dem eine dotierte Siliziumstruktur (8) erzeugt wird, die mindestens die Seitenwände (61) des Grabens (6) bedeckt,
- bei dem zur Bildung der dotierten Siliziumstruktur (8) eine dotierte Siliziumschicht (7) mit im wesentlichen konformer Kantenbedeckung in einer Dicke erzeugt wird, die geringer als die halbe Weite des Grabens (6) ist,
- bei dem die dotierte Siliziumschicht (7) in situ dotiert abgeschieden wird,
- bei dem die dotierte Siliziumschicht (7) amorph abgeschieden wird,
- bei dem die dotierte Siliziumschicht (7) anisotrop selektiv zu SiO₂ geätzt wird, so daß waagerechte Oberfläche der Grabenmaske (4) und der SiO₂-Schicht (2) freigelegt werden und daß an senkrechten Flanken der monokristallinen Siliziumschicht (3) und der Grabenmaske (4) dotierte Siliziumspacer (8) verbleiben, die die dotierte Siliziumstruktur (8) bilden,
- bei dem durch Ausdiffusion aus der dotierten Siliziumstruktur (8) in der monokristallinen Siliziumschicht (3) dem Graben (6) benachbarte Diffusionsgebiete (11) erzeugt werden,
- bei dem durch Aufoxidation der dotierten Siliziumstruktur (8) eine Isolationsstruktur (9) im Graben (6) erzeugt wird,
- bei dem die Ausdiffusion aus der dotierten Siliziumstruktur (8) in oxidierender Atmosphäre erfolgt, so daß es gleichzeitig mit der Ausdiffusion zur Aufoxidation der dotierten Siliziumstruktur (8) kommt.

2. Verfahren nach Anspruch 1,
bei dem die Ausdiffusion und die Aufoxidation im Temperaturbereich zwischen 900°C und 1200°C in feuchter Atmosphäre erfolgt.

3. Verfahren nach Anspruch 1 oder 2,
bei dem die dotierte Siliziumschicht (7) bei 400°C bis 550°C unter Verwendung von SiH₄ oder Si₂H₆ abgeschieden wird.

4. Verfahren nach einem der Ansprüche 1 bis 3,
- bei dem die Grabenmaske (4) mindestens an der Oberfläche SiO₂ umfaßt, und
- bei dem die Ätzung des Grabens (6) selektiv zu SiO₂ erfolgt.

5. Verfahren nach einem der Ansprüche 1 bis 4,
bei dem durch Abscheiden und Rückätzen einer weiteren Siliziumschicht (12) verbliebener Freiraum innerhalb der Isolationsstruktur (9) im Graben (6) mit einer Siliziumfüllung (121) aufgefüllt wird.

6. Verfahren nach Anspruch 5,
- bei dem die Grabenmaske (4) als Schichtenfolge aus einer unteren Schicht (41) aus thermischem SiO₂, einer mittleren Schicht (42) aus CVD-Si₃N₄ und einer oberen Schicht (43) aus CVD-SiO₂ gebildet wird,
- bei dem das Rückätzen der weiteren Siliziumschicht (12) so ausgelegt wird, daß die Siliziumfüllung (121) unterhalb der unteren Schicht (41) der Grabenmaske (4) abschließt,
- bei dem eine zu Si₃N₄ selektive Ätzung durchgeführt wird, in der die obere Schicht (43) der Grabenmaske (4) entfernt wird und in der die Isolationsstruktur (9) im oberen Bereich rückgeätzt wird, so daß sie im wesentlichen mit der mittleren Schicht (42) der Grabenmaske (4) abschließt,
- bei dem die Oberfläche der Siliziumfüllung (121) aufoxidiert wird, so daß ein Isolationsabschluß (13) entsteht, der die Siliziumfüllung (121) vollständig abdeckt.

7. Verfahren nach Anspruch 6,
bei dem die Aufoxidation zur Bildung des Isolationsabschlusses (13) im Temperaturbereich zwischen 900°C und 1200°C in feuchter Atmosphäre erfolgt.

8. Verfahren nach einem der Ansprüche 1 bis 7,
bei dem innerhalb der Isolationsstruktur (9) im Graben (6) verbliebener Freiraum in einem CVD-Verfahren unter Verwendung eines O₃ und Si(OC₂H₅)₄ enthaltenden Prozeßgases mit SiO₂ aufgefüllt wird.

## Claims

1. Process for fabricating an insulation trench in an SOI substrate in which logic components and high-voltage power components are integrated,
- in which the SOI substrate comprises a monocrystalline silicon wafer (1), an insulating layer (2) made of SiO₂ and arranged on top of the latter, and a monocrystalline silicon layer (3) arranged on top of the latter,
- in which a trench (6) is etched into the monocrystalline silicon layer (3) with the aid of a trench mask (4) and reaches down to the insulating layer (2),
- in which a doped silicon structure (8) is produced, which covers at least the side walls (61) of the trench (6),
- in which, in order to form the doped silicon structure (8), a doped silicon layer (7) is produced with essentially conformal edge covering with a thickness which is less than half the width of the trench (6),
- in which the doped silicon layer (7) is deposited in a manner doped in situ,
- in which the doped silicon layer (7) is deposited amorphously,
- in which the doped silicon layer (7) is anisotropically etched selectively with respect to SiO₂, with the result that horizontal surfaces of the trench mask (4) and of the SiO₂ layer (2) are uncovered and that doped silicon spacers (8) remain on vertical sidewalls of the monocrystalline silicon layer (3) and of the trench mask (4), which silicon spacers form the doped silicon structure (8),
- in which diffusion regions (11) adjacent to the trench (6) are produced by outdiffusion from the doped silicon structure (8) in the monocrystalline silicon layer (3),
- in which an insulation structure (9) is produced in the trench (6) by oxidation of the doped silicon structure (8),
- in which the outdiffusion from the doped silicon structure (8) is performed in an oxidizing atmosphere, with the result that the oxidation of the doped silicon structure (8) occurs at the same time as the outdiffusion.

2. Process according to Claim 1,
in which the outdiffusion and the oxidation are performed in a humid atmosphere in the temperature range of between 900°C and 1200°C.

3. Process according to Claim 1 or 2,
in which the doped silicon layer (7) is deposited at from 400°C to 550°C using SiH₄ or Si₂H₆.

4. Process according to one of Claims 1 to 3,
in which the trench mask (4) comprises SiO₂ at least at the surface, and
- in which the trench (6) is etched selectively with respect to SiO₂.

5. Process according to one of Claims 1 to 4, in which, as a result of the deposition and etching back of a further silicon layer (12), free space that has remained within the insulation structure (9) in the trench (6) is filled with a silicon filling (121).

6. Process according to Claim 5,
- in which the trench mask (4) is formed as a layer sequence comprising a bottom layer (41) made of thermal SiO₂, a middle layer (42) made of CVD-Si₃N₄ and a top layer (43) made of CVD-SiO₂,
- in which the etching back of the further silicon layer (12) is designed in such a way that the silicon filling (121) terminates below the bottom layer (41) of the trench mask (4),
- in which etching which is selective with respect to Si₃N₄ is carried out, in which the top layer (43) of the trench mask (4) is removed and in which the insulation structure (9) is etched back in the upper region, with the result that it terminates essentially with the middle layer (42) of the trench mask (4),
- in which the surface of the silicon filling (121) is oxidized, producing an insulation termination (13) which completely covers the silicon filling (121).

7. Process according to Claim 6,
in which the oxidation for the purpose of forming the insulation termination (13) is performed in a humid atmosphere in the temperature range of between 900°C and 1200°C.

8. Process according to one of Claims 1 to 7,
in which free space that has remained within the insulation structure (9) in the trench (6) is filled with SiO₂ in a CVD process using a process gas containing O₃ and Si(OC₂H₅)₄.

## Revendications

1. Procédé de fabrication d'une rainure d'isolation dans un substrat SOI, dans lequel des composants logiques et des composants de puissance à haute tension sont intégrés,
- dans lequel le substrat SOI comprend une tranche de silicium (1) monocristallin sur laquelle est disposée une couche isolante (2) en SiO₂ sur laquelle est disposée une couche de silicium monocristallin (3),
- dans lequel, à l'aide d'un masque de rainure (4), une rainure (6) qui s'étend jusqu'à la couche isolante (2) est gravée dans la couche de silicium monocristallin (3),
- dans lequel une structure de silicium dopé (8) est créée, qui recouvre au moins les parois latérales (61) de la rainure (6),
- dans lequel, pour former la structure de silicium dopé (8), on crée une couche de silicium dopé (7) avec un recouvrement des bords essentiellement conforme, sur une épaisseur qui est inférieure à la moitié de la largeur de la rainure (6),
- dans lequel la couche de silicium dopé (7) est déposée dopée in situ,
- dans lequel la couche de silicium dopé (7) est déposée à l'état amorphe,
- dans lequel la couche de silicium dopé (7) est gravée de manière anisotropique sélective par rapport à SiO₂ de telle sorte que des surfaces horizontales du masque de rainure (4) et de la couche de SiO₂ (2) soient découvertes, et que sur des flancs verticaux de la couche de silicium monocristallin (3) et du masque de rainure (4) restent des écarteurs en silicium dopé (8) qui forment la structure de silicium dopé (8),
- dans lequel, par diffusion à partir de la structure de silicium dopé (8) dans la couche de silicium monocristallin (3), des domaines de diffusion (11) voisins de la rainure (6) sont créés,
- dans lequel, par oxydation de la structure de silicium dopé (8), une structure d'isolation (9) est créée dans la rainure (6),
- dans lequel la diffusion à partir de la structure de silicium dopé (8) s'effectue dans une atmosphère oxydante, de sorte qu'en même temps que la diffusion s'effectue l'oxydation de la structure de silicium dopé (8).

2. Procédé selon la revendication 1,
dans lequel la diffusion et l'oxydation s'effectuent dans une plage de température entre 900°C et 1200°C dans une atmosphère humide.

3. Procédé selon la revendication 1 ou 2,
dans lequel la couche de silicium dopé (7) est déposée entre 400°C et 550°C en recourant à SiH₄ ou Si₂H₆.

4. Procédé selon l'une des revendications 1 à 3,
- dans lequel le masque de rainure (4) comprend du SiO₂ au moins en surface, et
- dans lequel la gravure de la rainure (6) s'effectue sélectivement par rapport à SiO₂.

5. Procédé selon l'une des revendications 1 à 4,
dans lequel, par dépôt et gravure en retrait d'une autre couche de silicium (12), l'espace libre restant à l'intérieur de la structure d'isolation (9) dans la rainure (6) est rempli d'un remplissage de silicium (121).

6. Procédé selon la revendication 5,
- dans lequel le masque de rainure (4) est formé comme succession de couches constituées d'une couche inférieure (41) en SiO₂ thermique, d'une couche centrale (42) en Si₃N₄ par CVD et d'une couche supérieure (43) en SiO₂ par CVD,
- dans lequel la gravure en retrait de l'autre couche de silicium (12) est conçue de telle sorte que le remplissage de silicium (121) finisse en dessous de la couche inférieure (41) du masque de rainure (4),
- dans lequel on effectue une gravure sélective par rapport à Si₃N₄, dans laquelle la couche supérieure (43) du masque de rainure (4) est enlevée et dans laquelle la structure d'isolation (9) dans la zone supérieure est gravée en retrait de telle sorte qu'elle se termine essentiellement au niveau de la couche centrale (42) du masque de rainure (4),
- dans lequel la surface du remplissage de silicium (121) est oxydée de telle sorte qu'apparaisse une fermeture d'isolation (13) qui recouvre complètement le remplissage de silicium (121).

7. Procédé selon la revendication 6,
dans lequel l'oxydation en vue de la formation de la fermeture d'isolation (13) s'effectue dans une plage de température entre 900°C et 1200°C, dans une atmosphère humide.

8. Procédé selon l'une des revendications 1 à 7,
dans lequel, à l'intérieur de la structure d'isolation (9), l'espace libre restant dans la rainure (6) est rempli de SiO₂ par un procédé de CVD recourant à un gaz de traitement contenant O₃ et Si(OC₂H₅)₄.
